# EUROPÄISCHE PATENTSCHRIFT

(11) **EP 0 899 363 B1**
(45) Veröffentlichungstag und Bekanntmachung des Hinweises auf die Patenterteilung: **24.01.2001**
(21) Anmeldenummer: 98115215.0
(22) Anmeldetag: 13.08.1998
(51) Int. Cl.: C30B 15/30

(54) **Verfahren und Vorrichtung zur Entlastung eines Impfkristalls**
Process and apparatus for reducing the load on a seed crystal
Procédé et dispositif pour réduire la charge sur un germe cristallin

(30) Priorität: 28.08.1997 DE 19737605
(43) Veröffentlichungstag der Anmeldung: 03.03.1999
(73) Patentinhaber: Wacker Siltronic Gesellschaft für Halbleitermaterialien Aktiengesellschaft, 84489 Burghausen (DE)
(72) Erfinder: Von Ammon, Wilfried Dr., 5122 Hochburg/Ach (AT)
(74) Vertreter: Rimböck, Karl-Heinz, Dr.

(56) Entgegenhaltungen:
- EP-A- 0 286 133
- JP-A- 9 202 691
- JP-A- 9 301 794
- PATENT ABSTRACTS OF JAPAN vol. 18, no. 46 (C-1157), 25. Januar 1994 & JP 05 270968 A (MITSUBISHI MATERIALS CORP)

## Beschreibung

Gegenstand der Erfindung ist ein Verfahren und eine Vorrichtung zur Entlastung eines Impfkristalls beim Ziehen eines Einkristalls gemäß Czochralski-Methode. Es dient insbesondere zur Herstellung von Einkristallen aus Silicium oder Verbindungshalbleitern für elektronische Zwecke. Bei dem Verfahren wird ein Impfkristall, der in eine Schmelze eintaucht, mit Hilfe einer Zieheinrichtung von der Schmelze weggezogen, wobei auf seiner Unterseite ein Einkristall aufwächst. Beim Ziehen wird darauf geachtet, daß zunächst ein sogenannter Dünnhals (neck) mit vergleichsweise kleinem Durchmesser entsteht, damit der Einkristall versetzungsfrei gezogen werden kann. Der Einkristalls umfaßt am Anfang einen konusförmigen Abschnitt mit ansteigendem Durchmesser, in der Mitte einen zylindrischen Abschnitt mit nahezu gleichbleibendem Durchmesser und am Ende einen konusförmigen Abschnitt mit fallendem Durchmesser. Üblicherweise ist nur der zylindrische Abschnitt als Grundprodukt für die Elektronikindustrie interessant.

JP-A-5270968 beschreibt ein Verfahren zur Verstärkung des Dünnhals eines Einkristalls. Bei diesem Verfahren wird PTFE um den Dünnhals gebracht.

In der US-4,973,518 ist bereits erwähnt, daß insbesondere der Dünnhals während des Ziehens des Einkristalls mit einem vergleichsweise hohen Gewicht axial zugbelastet werden kann. Jede transversale Krafteinwirkung sollte jedoch vermieden werden, da schon bei geringer Belastung die Gefahr besteht, daß der Dünnhals abbricht. Zur Vermeidung dieser Gefahr wird vorgeschlagen, den konusförmigen Abschnitt so zu ziehen, daß er an einer axialen Position im Durchmesser aufgeweitet ist und einen Wulst ausbildet, an dem der Einkristall mit einer Greifvorrichtung abgestützt werden kann.

Das Verfahren hat insbesondere in Bezug auf die Herstellung von Einkristallen Nachteile, die im zylindrischen Abschnitt Durchmesser von ≥200 mm haben. So ist das zur Erzeugung des Wulstes notwendige Material für elektronische Zwecke nicht verwendbar. Weiterhin ist das Ziehen der besonderen Form nicht einfach, und wenn es dabei nicht gelingt, dem Wulst eine exakte rotationssymmetrische Form zu geben, kann beim Ansetzen der Greifvorrichtung nicht sicher ausgeschlossen werden, daß der Dünnhals durch transversale Kräfte belastet wird. Selbst wenn dadurch der Dünnhals nicht abbricht, besteht die Gefahr, daß die Rotationsachse des Einkristalls verschoben wird, und der zylindrische Abschnitt nicht mehr gerade aufwächst.

Aufgabe der vorliegenden Erfindung ist, die geschilderten Probleme zu vermeiden und zu erreichen, daß insbesondere auch vergleichsweise schwere Einkristalle gezogen werden können.

Gegenstand der Erfindung ist ein Verfahren zur Entlastung eines Impfkristalls beim Ziehen eines Einkristalls mittels einer Zieheinrichtung, das dadurch gekennzeichnet ist, daß zwischen einem konusförmigen Abschnitt am Anfang des Einkristalls und einem Haltekörper eine Klebeverbindung hergestellt wird und der Impfkristall entlastet wird, indem zwischen dem Haltekörper und der Zieheinrichtung eine Zugspannung aufgebaut wird, die der Gewichtskraft des Einkristalls entgegenwirkt.

Die Erfindung ermöglicht auch das Ziehen von schweren Einkristallen, deren Gewicht über der Belastungsgrenze des Dünnhalses für axiale Zugbelastung liegt. Da der Einkristall bei Anwendung der Erfindung nur parallel zu seiner Längsachse belastet wird, sind Probleme, die sich bei transversaler Belastung ergeben, ausgeschlossen.

Gegenstand der Erfindung ist auch eine Vorrichtung zur Entlastung eines Impfkristalls beim Ziehen eines Einkristalls mittels einer Zieheinrichtung aus einer Schmelze, die gekennzeichnet ist durch einen Haltekörper und eine Klebeverbindung zwischen dem Haltekörper und einem konusförmigen Abschnitt am Anfang des Einkristalls, und eine Anordnung zum Aufbau einer Zugspannung zwischen dem Haltekörper und der Zieheinrichtung, die der Gewichtskraft des Einkristalls entgegenwirkt.

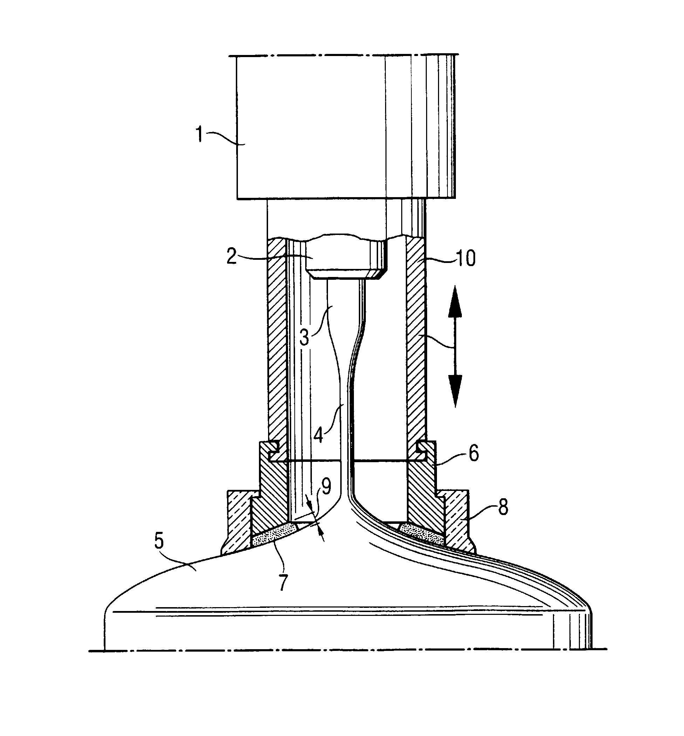

Die Erfindung wird nachfolgend an Hand einer Figur näher erläutert. Die Figur zeigt eine schematische Schnittdarstellung einer bevorzugten Ausführungsform der Vorrichtung in Seitenansicht. Es sind nur die zum Verständnis der Erfindung notwendigen Merkmale der Vorrichtung dargestellt.

Als Ziehvorrichtung ist eine Ziehwelle 1 eingesetzt, die eine Halterung 2 aufweist, in die ein Impfkristall 3 eingespannt ist. Gemäß der Darstellung sind bereits der Dünnhals 4 und der konusförmige Abschnitt 5 am Anfang des Einkristalls gezogen. Zwischen Oberfläche des konusförmigen Abschnittes 5 und dem Haltekörper 6 besteht eine Klebeverbindung 7. Gemäß der dargestellten, bevorzugten Ausführungsform hat der Haltekörper eine hohlzylindrische Form und ist von einem Dichtring 8 umgeben, der ebenfalls auf der Oberfläche des konusförmigen Abschnittes aufliegt. Der Dichtring dichtet einen Spalt 9 ab, der mit der Klebeverbindung ausgefüllt ist. Zwischen dem Haltekörper 6 und der Ziehwelle 1 besteht eine verkürzbare Verbindung, die durch ein axial verfahrbares Gestänge 10 geschaffen wird. Das Gestänge ist an einem Ende in der Ziehwelle verankert und an einem Ende mit dem Haltekörper verbunden.

Beim Ziehen des Einkristalls wird gewartet, bis der konusförmige Abschnitt 5 am Anfang des Einkristalls zumindest soweit gezogen ist, daß seine Oberfläche groß genug ist, um eine Klebeverbindung zwischen dem konusförmigen Abschnitt und dem Haltekörper 6 herzustellen. Der konusförmige Abschnitt muß auf eine bestimmte Temperatur T₁ abgekühlt sein, die auf die Eigenschaften des Materials abgestimmt ist, aus dem die Klebeverbindung bestehen soll. Besonders geeignet sind temperaturabhängig härtende Stoffe, wie Glas, mit Glasfasern verstärktes Glas, Germanium und Silber. Dieses Material wird mit der Oberfläche des konusförmigen Abschnitts in Kontakt gebracht. Die Temperatur T₁ muß ausreichend hoch sein, damit das Material durch den Kontakt flüssig oder zumindest weich wird. Der Dichtring 8 wird bereitgestellt, um flüssiges Material daran zu hindern, über die Schulter des konusförmigen Abschnitts zur Schmelze zu gelangen. Der Dichtring wird zusammen mit dem Haltekörper zur Oberfläche des konusförmigen Abschnitts abgesenkt, bis er diese berührt, wobei er im der Kontaktbereich aufweichen kann. Der Dichtring ist vorzugsweise aus Glas oder aus glasfaserverstärktem Glas gefertigt. Nach dem Aufsetzen des Dichtrings besteht zwischen der Oberfläche des konusförmigen Abschnittes und dem Haltekörper ein Spalt 9, der mit der Klebeverbindung 7 ausgefüllt wird. Das für die Klebeverbindung verwendete Material, beispielsweise Granulat aus Germanium, wird auf die Oberläche des konusförmigen Abschnittes gebracht, wo es flüssig wird und in den nach außen abgedichteten Spalt eindringt.

Auf einen Dichtring kann verzichtet werden, wenn das für die Klebeverbindung verwendete Material beim Kontakt mit dem Einkristall zwar weich wird, aber zu viskos bleibt, um den Kontaktbereich verlassen zu können. In diesem Fall wird ein Haltekörper zur Oberfläche des konusförmigen Abschnitts abgesenkt, der insgesamt oder zumindest dort, wo der Kontakt mit der Oberfläche des konusförmigen Abschnitts hergestellt wird aus einem Material gefertigt ist, das sich als Klebeverbindung eignet.

Im weiteren Verlauf des Ziehens des Einkristalls kühlt der konusförmige Abschnitt weiter ab, wobei das Material für die Klebeverbindung aushärtet. Wenn der konusförmige Abschnitt auf eine Tempertur T₂ < T₁ abgekühlt ist, kann der Impfkristall entlastet werden. Dazu wird das Gestänge 10 angehoben und eine Zugspannung aufgebaut, die der Gewichtskraft des Einkristalls entgegenwirkt. Der Betrag dieser Zugspannung wird zweckmäßigerweise während des Ziehens des Einkristalls in Abhängigkeit der zunehmenden Einkristall-Masse erhöht.

## Patentansprüche

1. Verfahren zur Entlastung eines Impfkristalls beim Ziehen eines Einkristalls mittels einer Zieheinrichtung, dadurch gekennzeichnet, daß zwischen einem konusförmigen Abschnitt am Anfang des Einkristalls und einem Haltekörper eine Klebeverbindung hergestellt wird und der Impfkristall entlastet wird, indem zwischen dem Haltekörper und der Zieheinrichtung eine Zugspannung aufgebaut wird, die der Gewichtskraft des Einkristalls entgegenwirkt.

2. Verfahren nach Anspruch 1, dadurch gekennzeichnet, daß die Klebeverbindung hergestellt wird, wenn der konusförmige Abschnitt des Einkristalls auf eine Temperatur T₁ abgekühlt ist, und die Zugspannung aufgebaut wird, wenn der konusförmige Abschnitt eine Temperatur T₂ abgekühlt ist.

3. Verfahren nach Anspruch 1 oder Anspruch 2, dadurch gekennzeichnet, daß die Zugspannung in Abhängigkeit der während des Ziehens des Einkristalls anwachsenden Einkristall-Masse gesteigert wird.

4. Vorrichtung zur Entlastung eines Impfkristalls beim Ziehen eines Einkristalls mittels einer Zieheinrichtung aus einer Schmelze, umfassend einen Haltekörper, der mittels einer Klebeverbindung mit einem konusförmigen Abschnitt am Anfang des Einkristalls verbunden ist, gekennzeichnet durch eine Anordnung zum Aufbau einer Zugspannung zwischen dem Haltekörper und der Zieheinrichtung, wobei die Zugspannung der Gewichtskraft des Einkristalls entgegenwirkt.

5. Vorrichtung nach Anspruch 4, dadurch gekennzeichnet, daß die Klebeverbindung aus einem Material besteht, das ausgewählt ist aus einer Gruppe, die Glas, mit Glasfasern verstärktes Glas, Germanium und Silber umfaßt.

6. Vorrichtung nach Anspruch 4 oder Anspruch 5, dadurch gekennzeichnet, daß der Haltekörper ein hohlzylindrische Form besitzt.

7. Vorrichtung nach einem der Ansprüche 4 bis 6, gekennzeichnet durch einen Dichttring, der auf dem Anfangskonus aufgesetzt ist und einen Spalt zwischen konusförmigen Abschnitt und dem Haltekörper abdichtet, wobei der Spalt zur Aufnahme der Klebeverbindung dient.

8. Vorrichtung nach einem der Ansprüche 4 bis 7, dadurch gekennzeichnet, daß die Zieheinrichtung eine Ziehwelle umfaßt und die Anordnung zum Aufbau einer Zugspannung ein parallel zur Längsachse des Einkristalls verfahrbares, den Haltekörper und die Ziehwelle verbindendes Gestänge umfaßt.

## Claims

1. Process for reducing the load on a seed crystal during the pulling of a single crystal by means of a pulling device, characterized in that an adhesive bond is made between a conical section at the start of the single crystal and a retaining body, and the load on the seed crystal is reduced by creating a tensile stress between the retaining body and the pulling device, which tensile stress counteracts the force due to the weight of the single crystal.

2. Process according to Claim 1, characterized in that the adhesive bond is made when the conical section of the single crystal is cooled to a temperature T₁, and the tensile stress is created when the conical section is cooled to a temperature T₂.

3. Process according to Claim 1 or Claim 2, characterized in that the tensile stress is increased as a function of the single crystal mass that grows as the single crystal is pulled.

4. Device for reducing the load on a seed crystal during the pulling of a single crystal from a melt by means of a pulling device, comprising a retaining body which is connected by means of an adhesive bond to a conical section at the start of the single crystal, characterized by an arrangement for creating a tensile stress between the retaining body and the pulling device, the tensile stress counteracting the force due to the weight of the single crystal.

5. Device according to Claim 4, characterized in that the adhesive bond consists of a material which is selected from a group comprising glass, glass reinforced with glass fibres, germanium and silver.

6. Device according to Claim 4 or 5, characterized in that the retaining body has a hollow cylindrical shape.

7. Device according to one of Claims 4 to 6, characterized by a sealing ring which is placed on the starting cone and seals a gap between the conical section and the retaining body, the gap serving to accommodate the adhesive bond.

8. Device according to one of Claims 4 to 7, characterized in that the pulling device comprises a pulling shaft, and the arrangement for creating a tensile stress comprises a rod system which can be moved parallel to the longitudinal axis of the single crystal and connects the retaining body and the pulling shaft.

## Revendications

1. Procédé de décharge d'un germe cristallin lors du tirage d'un monocristal au moyen d'un dispositif de tirage, caractérisé en ce qu'on établit une liaison adhésive entre une section conique au départ du monocristal et un corps de retenue et le germe cristallin est déchargé en créant entre le corps de retenue et le dispositif de tirage une contrainte de traction qui s'oppose à la force pondérale du monocristal.

2. Procédé selon la revendication 1, caractérisé en ce que la liaison adhésive est établie lorsque la section conique du monocristal est refroidie à une température T₁ et la contrainte de traction est créée lorsque la section conique est refroidie à une température T₂.

3. Procédé selon la revendication 1 ou 2, caractérisé en ce que la contrainte de traction est augmentée en fonction de la masse de monocristal croissant lors du tirage du monocristal.

4. Dispositif pour décharger un germe cristallin lors du tirage d'un monocristal au moyen d'un dispositif de tirage d'une masse fondue, comprenant un corps de retenue, qui est relié par une liaison adhésive à une section conique au départ du monocristal, caractérisé par un agencement permettant de créer une contrainte de traction entre le corps de retenue et le dispositif de tirage, la contrainte de traction s'opposant à la force pondérale du monocristal.

5. Dispositif selon la revendication 4, caractérisé en ce que la liaison adhésive est constituée d'un matériau choisi dans le groupe comprenant le verre, le verre renforcé aux fibres de verre, le germanium et l'argent.

6. Dispositif selon la revendication 4 ou la revendication 5, caractérisé en ce que le corps de retenue présente une forme cylindrique creuse.

7. Dispositif selon l'une quelconque des revendications 4 à 6, caractérisé par une bague d'étanchéité, qui est appliquée sur le cône de départ et étanche un intervalle entre la section conique et le corps de retenue, l'intervalle servant à recevoir la liaison adhésive.

8. Dispositif selon l'une quelconque des revendications 4 à 7, caractérisé en ce que le dispositif de tirage comprend un arbre de tirage et l'agencement prévu pour créer une contrainte de traction comprend une tringlerie reliant le corps de retenue et l'arbre de tirage et qui peut se déplacer parallèlement à l'axe longitudinal du monocristal.
